Europäisches Patentamt

European Patent Office

Office européen des brevets

(19)

(11) Veröffentlichungsnummer: **0 313 968 B1**

(12) **EUROPÄISCHE PATENTSCHRIFT**

(45) Veröffentlichungstag der Patentschrift: **11.12.91**

(51) Int. Cl.5: **G01J 3/28**, H01L 31/10

(21) Anmeldenummer: **88117335.5**

(22) Anmeldetag: **18.10.88**

(54) **Anordnung zur hochauflösenden Spektroskopie.**

(30) Priorität: 26.10.87 DE 3736204
18.12.87 DE 3743131

(43) Veröffentlichungstag der Anmeldung:
**03.05.89 Patentblatt 89/18**

(45) Bekanntmachung des Hinweises auf die
Patenterteilung:
**11.12.91 Patentblatt 91/50**

(84) Benannte Vertragsstaaten:
**DE FR GB IT NL**

(56) Entgegenhaltungen:
**GB-A- 2 108 760**
**US-A- 4 492 434**

**PATENT ABSTRACTS OF JAPAN, Band 9, Nr.
37 (P-335)[1760], 16. Februar 1985 & JP-
A-59-180 310**

**PATENT ABSTRACTS OF JAPAN, Band 6, Nr.
217 (P-152)[1095], 30. Oktober 1982 & JP-
A-57-120 829**

**PATENT ABSTRACTS OF JAPAN, Band 6, Nr.
108 (P-123)[986], 18. Juni 1982 & JP-A-57-39
323**

(73) Patentinhaber: **SIEMENS AKTIENGESELL-
SCHAFT**
**Wittelsbacherplatz 2**
**W-8000 München 2(DE)**

(72) Erfinder: **Albertshofer, Wolfgang, Dipl.-Ing.**
**Birkenweg 9**
**W-8085 Geltendorf(DE)**
Erfinder: **Müller, Rudolf, Prof. Dr.**
**Ahornweg 22**
**W-8135 Söcking(DE)**

## Beschreibung

Die Erfindung betrifft eine Anordnung zur hochauflösenden Spektroskopie, die ein wellenlängenselektives Diodenarray mit nebeneinander angeordneten Diodenelementen mit unterschiedlicher spektraler Empfindlichkeit enthält.

Spektroskopische Methoden spielen in der Physik und der Chemie eine bedeutende Rolle. In vielen Anwendungen ist es wünschenswert, handliche kompakte Spektrometer zu Verfügung zu haben.

Es ist bekannt (siehe zum Beispiel R. F. Wolffenbuttel, Proceedings of the International Conference on Solid State Sensors and Actuators - Transducers 87, Tokyo 1987, Seite 219 ff., F. Koike et. al., A new type amorphous silicon full color sensor, Transducers 87, Tokyo 1987, Seite 223 ff.), Photodioden mit "integriertem" Farbfilter als Spektrometer zu verwenden. Dabei wird ausgenutzt, daß die Eindringtiefe von optischer Strahlung in Silizium wellenlängenabhängig ist. Der Einzugsbereich für Ladungsträger und damit die gesamte Wellenlängenabhängigkeit des Photostroms kann durch die an die Diode angelegte Sperrspannung gesteuert werden. Die Photodiode wird so betrieben, daß sie drei Farbempfindlichkeitsbereiche hat.

Aus W. Albertshofer, A. Gerhard, Flüssigkeitsanalyse unter Verwendung einer Spektrometerdiode, Proceedings of Sensoren-Technologie und Anwendung, Bad Nauheim, FRG, 1986, NTG-Fachberichte 93, appendix Seite 30, ist eine sogenannte Spektrometerdiode bekannt. Diese Spektrometerdiode ist eine Anordnung von Photodioden, die nebeneinander angeordnet sind und die in unterschiedlichen Wellenlängenbereichen empfindlich sind. Die Diode ist als Schichtaufbau aus einem Halbleitermaterial mit stetig veränderlichem Bandabstand realisiert. Die Diode wird von der Seite mit dem größeren Bandabstand her bestrahlt. Die Photonen dringen bis in die Tiefe in den Halbleiter ein, in der sie aufgrund des Bandabstandes absorbiert werden können. Durch Schrägschliff der Rückseite der Diode ist es möglich, an Stellen verschiedenen Bandabstandes Schottky-Kontakte anzubringen, an denen jeweils ein der entsprechenden Wellenlänge zuzuordnendes Signal abgegriffen wird.

Die beschriebenen Dioden weisen ein Auflösungsvermögen auf, das für viele Anwendungen zu klein ist.

Der Erfindung liegt die Aufgabe zugrunde, eine Anordnung zur Spektroskopie anzugeben mit einem gegenüber dem Stand der Technik verbesserten Auflösungsvermögen.

Die Aufgabe wird erfindungsgemäß durch eine Anordnung nach dem Oberbegriff des Anspruchs 1 gelöst, wie dies im kennzeichnenden Teil des Anspruchs 1 angegeben ist. Weitere Ausgestaltungen der Erfindung gehen aus den Unteransprüchen hervor.

Die Anordnung zur hochauflösenden Spektroskopie enthält ein wellenlängenselektives Diodenarray, das aus einem Halbleitermaterial besteht, und ein räumlich oder zeitlich abstimmbares Interferenzfilter. Es ist besonders vorteilhaft, das wellenlängenselektive Diodenarray mit dem abstimmbaren Interferenzfilter als integrierten Baustein aufzubauen.

Das Auflösevermögen, das für eine Halbleiterdiode erreicht werden kann, ist durch die grundlegenden Mechanismen im Halbleiter prinzipiell auf Werte um etwa 20 nm (s. A. Piotrowski, Entwurf optimaler Spektrometerdioden, Dissertation, TU München, Lehrstuhl für technische Elektronik, 1976) begrenzt. Mit einem Interferenzfilter kann diese Auflösung bei weitem übertroffen werden. Interferenzfilter haben mehrere scharfe Durchlaßmaxima. Bei der Kombination eines wellenlängenselektiven Diodenarrays mit einem Interferenzfilter sind die Elemente so aufeinander abzustimmen, daß der Abstand zweier Interferenzmaxima dem Abstand der Empfindlichkeitsmaxima von zwei im Diodenarray enthaltenen Diodenelementen entspricht. Durch hintereinander Anordnen des Inferenzfilters und des Diodenarrays wird so die Auflösung optimiert. Um den gesamten Empfindlichkeitsbereich des Diodenarrays abzudecken, wird je ein Durchlaßbereich des Interferenzfilters zwischen zwei benachbarten Empfindlichkeitsmaxima der Diodenelemente durchgestimmt.

Durch die Integration des Interferenzfilters mit dem Diodenarray ist eine sehr kompakte Bauweise möglich.

Die Erfindung wird anhand von Ausführungsbeispielen, die in den Figuren dargestellt sind, näher erläutert.

Figur 1     zeigt eine Anordnung zur hochauflösenden Spektroskopie mit einem wellenlängenselektiven Diodenarray und einem keilförmigen Interferenzfilter.

Figur 2     zeigt die Empfindlichkeit der einzelnen Diodenelemente eines Diodenarrays als Funktion der Wellenlänge.

Figur 3     zeigt die Wellenlängenempfindlichkeit der Diodenelemente, die Interferenzmaxima eines Interferenzfilters und den Bereich, über den ein Interferenzmaximum eines Interferenzfilters abstimmbar ist.

Figur 4     zeigt eine Anordnung zur hochauflösenden Spektroskopie mit einem wellenlängenselektiven Diodenarray und einem planparallelen Interferenzfilter.

Figur 5     zeigt ein planparalleles Interferenzfilter, das elektromechanisch abstimmbar ist und das z. B. Piezokristalle enthält.

Figur 6     zeigt eine weitere Ausführung eines planparallelen Interferenzfilters, das elektromechanisch oder thermisch abstimmbar ist.

Figur 7     zeigt die Transmissionskurve einer dielektrischen planparallelen Platte für senkrechten Lichteinfall (durchgezogene Kurve) und für um 20° aus der Senkrechten verkippten Lichteinfall (gestrichelte Kurve).

Figur 8     zeigt die relative Wellenlängenverschiebung in Abhängigkeit vom Verkippungswinkel gegenüber senkrechtem Lichteinfall für eine planparallele dielektrische Platte mit einem effektiven Brechungsindex von 2,0 (durchgezogene Kurve) bzw. einem effektiven Brechungsindex von 1,45 (gestrichelte Kurve).

Figur 9     zeigt ein Interferenzfilter, das eine dielektrische planparallele Platte enthält, die mit Hilfe zweier Piezokristalle verkippt werden kann.

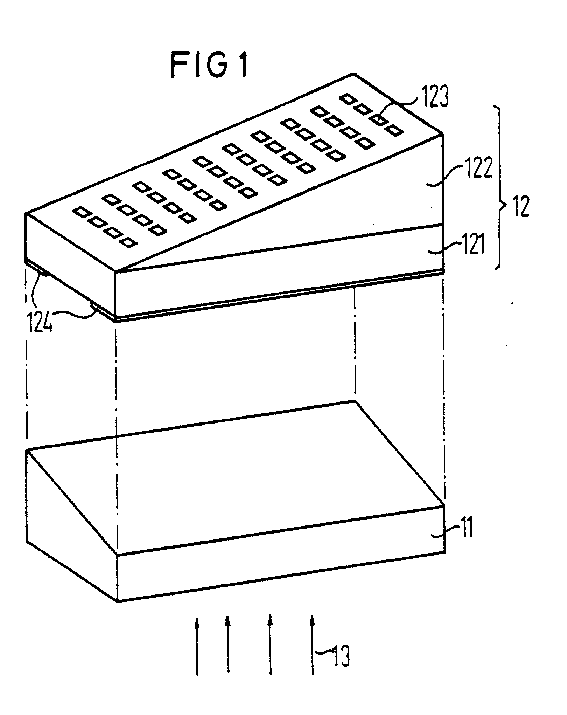

In der Anordnung in Fig. 1 ist ein keilförmiges Interferenzfilter 11 vorgesehen. Das keilförmige Interferenzfilter 11 besteht aus einem für das zu untersuchende Licht durchlässigen Material. Es ist ein erstes Diodenarray 12 vorgesehen. Das erste Diodenarray 12 ist auf einem ersten Substrat 121 aufgebaut. Auf das erste Substrat 121 folgt ein erster Schichtaufbau 122. Das erste Diodenarray 12 besteht aus einem Halbleitermaterial. Der Bandabstand im Halbleitermaterial nimmt in der Richtung senkrecht zum ersten Schichtaufbau 122 vom ersten Substrat 121 her stetig ab. Im ersten Substrat 121 ist der Bandabstand am größten, an dem dem ersten Substrat 121 abgewandten Ende des ersten Schichtaufbaus 122 ist er am kleinsten. Die dem ersten Substrat 121 abgewandte Oberfläche des ersten Schichtaufbaus 122 ist schräg abgeschliffen. Auf dieser schräg abgeschliffenen Fläche sind erste Kontakte 123 aufgebracht. Die ersten Kontakte 123 sind als zweidimensionales Feld, das von der Richtung der Neigung der abgeschliffenen Oberfläche und der Richtung senkrecht zur Richtung der Neigung und parallel zur abgeschliffenen Oberfläche aufgespannt wird, angeordnet. In Richtung der Neigung der abgeschliffenen Oberfläche ändert sich der Bandabstand stetig, so daß in dieser Richtung je zwei benachbarte Kontakte einen unterschiedlichen Bandabstandsbereich sehen. Die ersten Kontakte 123 sind Schottky-Kontakte, d.h. sperrende Schottky-Dioden. Die ersten Kontakte 123 bestehen z. B. aus Gold. Auf der dem ersten Schichtaufbau 122 abgewandten Seite des ersten Substrats 121 ist ein erster ohmscher Kontakt 124 vorgesehen. Der erste ohmsche Kontakt 124 ist so mit Aussparungen versehen, daß das Licht, angedeutet als erste Pfeile 13, durch den ersten ohmschen Kontakt 124 in das erste Substrat 121 eindringen kann. Das erste Diodenarray 12 ist zum Beispiel für den Wellenlängenbereich von 650 bis 900 nm empfindlich. In diesem Beispiel besteht das erste Substrat 121 und der erste Schichtaufbau 122 aus $GaAs_{1-p}P_p$, wobei im ersten Substrat 121 der Mischungsindex p den Wert 0,4 annimmt, im ersten Schichtaufbau 122 der Mischungsindex p die Werte zwischen 0,4 und 0 annimmt. Damit besteht die oberste Schicht des ersten Schichtaufbaus 122 aus GaAs.

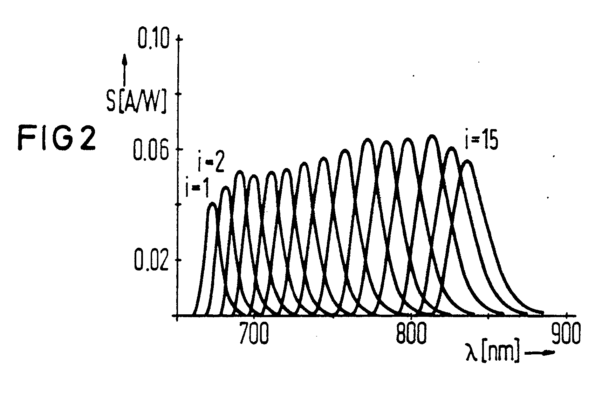

Die Empfindlichkeiten S der Diodenelemente des ersten Diodenarrays 12 sind als Funktion der Wellenlänge in Fig. 2 dargestellt. Die Empfindlichkeitskurve jedes einzelnen Diodenelementes ist näherungsweise glockenförmig. Die einzelnen Diodenelemente überlappen sich teilweise.

Das keilförmige Interferenzfilter 11 wird so zum ersten Diodenarray 12 angeordnet, daß die Richtung der Neigung des keilförmigen Interferenzfilters 11 senkrecht zur Richtung der Neigung der abgeschliffenen Oberfläche des ersten Diodenarrays 12 verläuft. Das keilförmige Interferenzfilter 11 wird unterhalb des ersten Substrats 121 angeordnet, so daß das Licht einer zu untersuchenden Probe, angedeutet als erste Pfeile 13, zunächst das keilförmige Interferenzfilter 11 durchstrahlt und dann vom ersten Substrat 121 her in das erste Diodenarray 12 gelangt. Das Licht dringt so tief in den ersten Schichtaufbau 122 ein, bis es die Schicht mit dem seiner Wellenlänge entsprechenden Bandabstand erreicht hat. Bei der Absorption werden Ladungsträger erzeugt, die über Signale an dem entsprechenden ersten Kontakt 123 nachgewiesen werden können. Die ersten Kontakte 123 sind in einem zweidimensionalen Feld angeordnet, das aus der Richtung der Neigung des keilförmigen Interferenzfilters 11 und der Richtung der Neigung der abgeschliffenen Oberfläche des ersten Schichtaufbaus 122 aufgespannt wird.

Die Dicke und die Neigung des keilförmigen Interferenzfilters 11 werden so gewählt, daß der Abstand der Durchlaßbereiche des keilförmigen Interferenzfilters 11 dem Abstand der Empfindlichkeitsmaxima des ersten Diodenarrays 12 entspricht und daß die Verschiebung jedes Durchlaßbereichs des keilförmigen Interferenzfilters 11 über die Breite des Keils den Bereich zwischen zwei Empfindlichkeitsmaxima des ersten Diodenarrays 12 abdeckt. Das keilförmige Interferenzfilter 11 besteht z. B. aus Calciumfluorid, Magnesiumfluorid, Siliziummonoxid. Die Dicke des keilförmigen Interferenzfilters 11 beträgt am Fuß der Neigung z.B. 14μm und auf der Höhe der Neigung z.B. 14,2μm, dabei

wurde ein Brechungsindex von 1,5 angenommen, der im Bereich der Brechungsindeces verwendeter Materialien liegt.

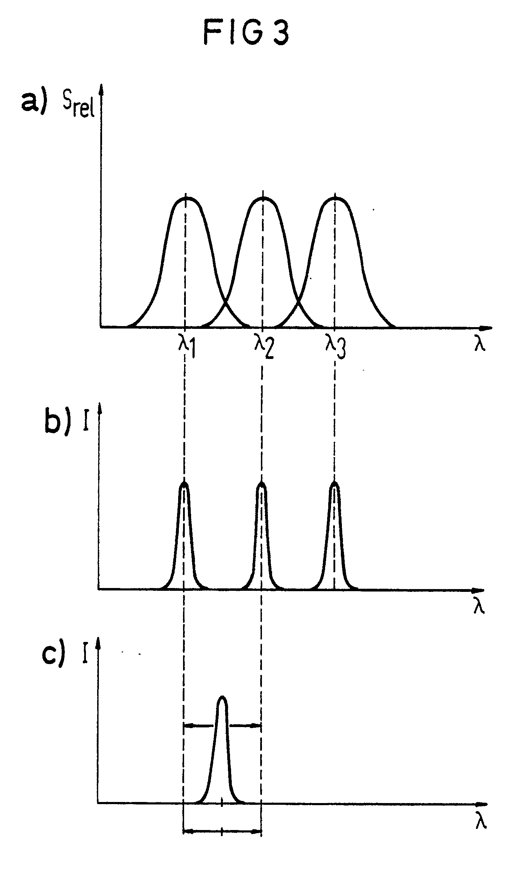

Im Teil a der Figur 3 sind Empfindlichkeitskurven für drei Diodenelemente dargestellt. Die Empfindlichkeitskurven haben Glockenform mit Maxima bei $\lambda_1$, $\lambda_2$ und $\lambda_3$. Die Kurven überlappen sich teilweise. Im Teil b der Figur 3 ist der Durchlaßbereich eines Interferenzfilters dargestellt. Er umfaßt ebenfalls drei Maxima. Das Interferenzfilter ist so gewählt, daß diese Maxima mit den Empfindlichkeitsmaxima $\lambda_1$, $\lambda_2$ und $\lambda_3$ zusammenfallen. Im Teil c der Figur 3 ist schematisch der Bereich dargestellt über den die Lage eines Durchlaßbereiches des Interferenzfilters abgestimmt werden können muß. Diese Abstimmung kann räumlich zum Beispiel durch ein keilförmiges Interferenzfilter erfolgen. Sie kann auch durch zeitliche Trennung erfolgen, wie dies zum Beispiel bei thermischer oder elektrischer Abstimmung eines planparallelen Interferenzfilters der Fall ist.

Ein Interferenzfilter der Dicke d läßt bei senkrechtem Einfall Licht der Wellenlänge durch, wenn die Wellenlänge $\lambda$ der Bedingung $\lambda = \frac{2\phi}{Z} \cdot \eta$ genügt, wobei n die Brechzahl des Interferenzfilters und Z eine natürliche Zahl ist. Durch Veränderung der Dicke d oder der Brechzahl n kann die optische Länge des Filters verändert werden, dabei verändert sich auch die durchgelassene Wellenlänge $\lambda$.

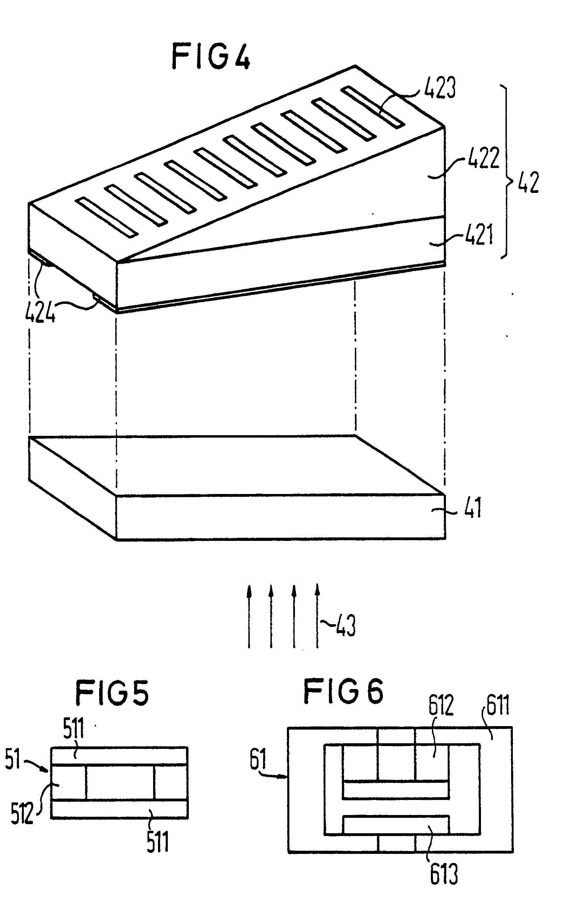

In Figur 4 ist ein erstes planparalleles Interferenzfilter 41 dargestellt. Es besteht aus einem Material, das für das zu untersuchende Licht durchlässig ist. Ferner ist in Figur 4 ein zweites Diodenarray 42 dargestellt. Wie das erste Diodenarray 12 ist das zweite Diodenarray 42 auf einem zweiten Substrat 421 aufgebaut. Es folgt ein zweiter Schichtaufbau 422 mit zweiten Kontakten 423. Das zweite Diodenarray 42 besteht aus einem Halbleitermaterial mit variablem Bandabstand. Im zweiten Substrat 421 ist der Bandabstand am größten und nimmt über den zweiten Schichtaufbau 422 hinweg ab. Die dem zweiten Substrat 421 abgewandte Oberfläche des zweiten Schichtaufbaus 422 ist schräg abgeschliffen. Auf dieser schrägen Oberfläche sind die zweiten Kontakte 423 angebracht. Pro Schicht des zweiten Schichtaufbaus 422 ist ein zweiter Kontakt 423 vorgesehen. Die zweiten Kontakte 423 sind ebenfalls Schottky-Kontakte. Auf der dem zweiten Schichtaufbau 422 abgewandten Seite des zweiten Substrats 421 ist ein zweiter ohmscher Kontakt 424 vorgesehen. Der zweite ohmsche Kontakt 424 ist so mit Aussparungen versehen, daß das Licht angedeutet als zweite Pfeile 43, durch den zweiten ohmschen Kontakt 424 hindurch in das zweite Substrat 421 eindringen kann. Das erste planparallele Interferenzfilter 41 wird zeitlich variablen äußeren Einflüssen ausgesetzt und dadurch zeitlich abgestimmt. Durch zeitliche Auflösung der an den zweiten Kontakten 423 abgetasteten Signale ist es möglich, die durch die Abstimmung des ersten planparallelen Interferenzfilters 41 erreichte Verbesserung der Auflösung mit nur einem zweiten Kontakt 423 pro Schicht des zweiten Schichtaufbaus 422 auszuwerten.

Das erste planparallele Interferenzfilter 41 ist so zum zweiten Diodenarray 42 angeordnet, daß Licht einer zu untersuchenden Probe, angedeutet durch zweite Pfeile 43, erst das erste planparallele Interferenzfilter 41 durchstrahlt und dann, vom zweiten Substrat 421 her, in das zweite Diodenarray 42 gelangt, wo es, wie oben beschrieben, analysiert wird.

Die Abstimmung des planparallelen Interferenzfilters 41 durch äußere Einflüsse ist zum Beispiel thermisch, elektromechanisch, magnetostriktiv oder elektrisch möglich. Das planparallele Interferenzfilter 41 ist zum Beispiel aus einem Piezokristall gefertigt, der für das zu untersuchende Licht durchlässig ist. Durch Anlegen einer elektrischen Spannung wird die Dicke des Interferenzfilters verändert. Dadurch ändern sich die von dem Interferenzfilter durchgelassenen Wellenlängen.

Das planparallele Interferenzfilter 41 ist zum Beispiel aus einem elektrisch doppelbrechenden Material, zum Beispiel Galliumarsenid, hergestellt. Durch Anlegen einer Spannung läßt sich auch in diesem Fall die Wellenlänge, die von dem planparallelen Interferenzfilter durchgelassen wird, beeinflussen.

Die Abstimmung kann langsam, d.h. quasi stationär, oder durch rasches Wobbeln erfolgen. Dabei findet die Wechselstrommeßtechnik, z.B. lock-in-Technik, Anwendung. Für eine Abstimmung von einem Durchlaßbereich zum nächsten ist die sogenannte Halbwellenspannung erforderlich, die für die meisten Materialien einige kV beträgt.

Ein weiteres Ausführungsbeispiel für ein zweites planparalleles Interferenzfilter 51, das Piezokristalle enthält, ist in Figur 5 dargestellt. Das zweite planparallele Interferenzfilter 51 enthält zwei erste Platten 511, die planparallel zueinander angeordnet sind. Die ersten Platten 511 werden durch Stege 512 miteinander verbunden. Jeweils eine der planparallelen Oberflächen jeder der beiden ersten Platten 511 ist vergütet, jeweils die andere Oberfläche ist teilverspiegelt. Es wird die Interferenz von Licht ausgenutzt, das an den teilverspiegelten Oberflächen reflektiert wird. Die Stege 512 bestehen z. B. aus Piezokristallen. Dadurch ist es möglich, den Abstand der ersten Platten 511 durch Anlegen einer elektrischen Spannung an die Stege 512 zu beeinflussen. Damit kann das zweite planparallele Interferenzfilter 51 elektromechanisch für verschiedene Wellenlängen durchgestimmt werden.

Die Stege 512 bestehen z. B. aus einem Material, das Magnetostriktion zeigt. Durch Magnetisieren der Stege 512 wird deren Länge verändert. Damit ändert sich auch der Abstand der beiden ersten Platten 511.

In Figur 6 ist ein drittes planparalleles Interferenzfilter 61 dargestellt. Es ist ein Joch 611 vorgesehen. Das Joch 611 ist zylinderförmig und weist auf beiden Grundplatten je eine kreisförmige Öffnung auf. Das Joch 611 enthält zwei parallel angeordnete zweite Platten 613. Die eine zweite Platte 613 ist innerhalb des Jochs 611 auf einer Grundplatte befestigt. Jeweils eine der planparallelen Oberflächen jeder der beiden zweiten Platten 613 ist vergütet, jeweils die andere Oberfläche ist teilverspiegelt. Das dritte planparallele Interferenzfilter 61 nutzt die Interferenz von Licht, das an den teilweise verspiegelten Oberflächen reflektiert wird. Die zweite zweite Platte 613 ist über ein Abstandsstück 612 an der anderen Grundplatte im Joch 611 befestigt. Das Abstandsstück 612 ist zum Beispiel ringförmig. Durch Variation der Dicke des Abstandsstücks 612 kann der Abstand der planparallelen zweiten Platten 613 variiert werden. Die Dicke des Abstandsstücks 612 kann zum Beispiel elektromechanisch beeinflußt werden. Das Abstandsstück 612 ist dann aus einem Piezokristall gefertigt. Durch Anlegen einer elektrischen Spannung an das Abstandsstück 612 wird dessen Dicke verändert. Da die eine zweite Platte 613 fest mit dem Abstandsstück 612 verbunden ist, verändert sich dadurch der Abstand der planparallelen zweiten Platten 613.

Eine weitere Möglichkeit, die Dicke des Abstandsstück 612 zu beeinflussen, besteht darin, die thermische Ausdehnung des Abstandsstücks 612 auszunutzen. Durch Aufheizen des Abstandsstücks 612 bei gleichzeitigem Kühlen des Jochs 611 verändert sich nur die Dicke des Abstandsstücks 612 und damit der Abstand der planparallelen zweiten Platten 613. In Fällen, in denen eine Kühlung des Jochs 611 unmöglich oder zu aufwendig ist, ist es günstig, das Joch 611 aus einem Material mit geringer Wärmeausdehnung, zum Beispiel Invar, zu fertigen.

Da die Dicke des Abstandsstücks 612 größer gewählt werden kann als die Dicke der Stege 512 im Ausführungsbeispiel der Fig. 5, kann durch Erwärmen des Abstandsstücks 612 eine größere Abstandsänderung der zweiten Platten 613 erzielt werden, als dies mit Erwärmung der Stege 512 im vorhergehenden Ausführungsbeispiel möglich wäre.

Der Abstand d der zweiten Platten 613 beträgt z.B. 14µm, die Abstandsänderung 0,2µm. Das Abstandsstück 612 hat eine Dicke D von z.B. 280µm, d.h. $D = k_1.d$ mit $k_1 = 20$. Damit genügt zur Ausdehnung des Abstandsstücks 612 um 0,2µ der

$k_1$-te Bruchteil der Temperatur $\Delta T$, die für eine Platte der Dicke d benötigt würde: $\Delta T_1 = \Delta T/k_1$
Um das Abstandsstück 612 aus z.B. Glas um 0,2µm auszudehnen, werden etwa 80· benötigt.

Da der Abstand der ersten Platten 511 in Fig. 5 ebenfalls z. B. 14 µm und die Abstandsänderung 0.2 µm beträgt, wäre eine Erwärmung der Stege 512 um $\Delta T = k_1.\Delta T_1$ nötig, was für Glas einem Wert von etwa 1600· entspricht.

Die Durchlaßcharakteristik einer planparallelen Platte, die aus dielektrischen Materialien besteht, z. B. aus ZnS oder Kryolith, ist vom Einfallswinkel der optischen Strahlung abhängig. Eine planparallele Platte der Dicke d läßt Licht der Wellenlänge durch, wenn die Wellenlänge der Bedingung

$$\lambda = \frac{2 n d}{z} \cdot \cos \alpha$$

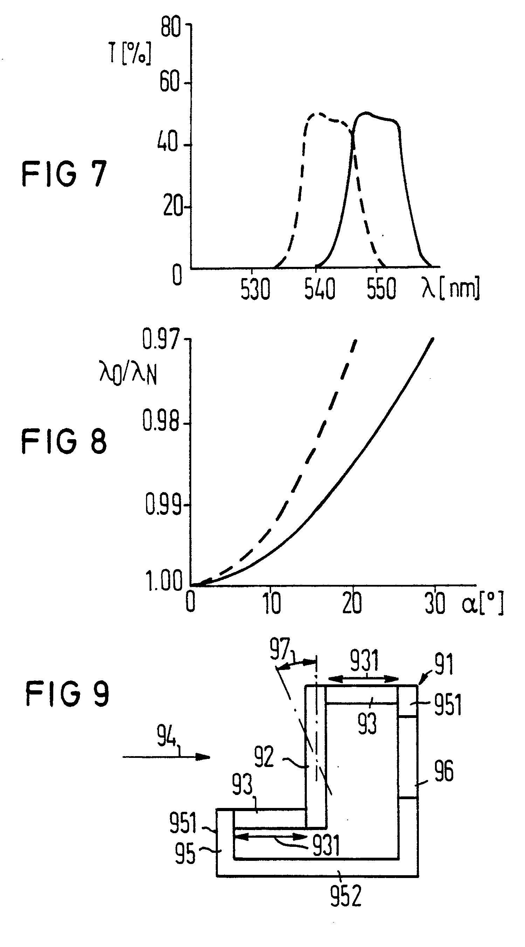

genügt wobei n die Brechzahl des Dielektrikums, z eine natürliche Zahl und $\alpha$ der interne Einfallswinkel des Lichtes ist. Mit Hilfe der Fig. 7 und 8, die Oriel, Optical Filters, Katalog entnommen sind, wird dieser Effekt veranschaulicht. In Fig. 7 ist die Transmission durch eine planparallele Platte als Funktion der Wellenlänge $\lambda$ für zwei verschiedene Einfallswinkel dargestellt. Der Brechungsindex der planparallelen Platte beträgt 2,0. Als durchgezogene Kurve ist die Transmission bei senkrechtem Lichteinfall, d. h. Einfallswinkel $\alpha = 0°$, dargestellt. Als gestrichelte Kurve ist die Transmission durch die planparallele Platte für einen Einfallswinkel von 20° dargestellt. Man sieht deutlich, daß es zu einer Verschiebung der mittleren durchgelassenen Wellenlänge kommt. In Fig. 8 ist das Verhältnis der durchgelassenen Wellenlänge bei Einfallswinkel 0° zur durchgelassenen Wellenlänge bei einem anderen Einfallswinkel als Funktion des Einfallswinkels für verschiedene Brechungsindices der planparallelen Platte dargestellt. Als durchgezogene Kurve ist diese relative Wellenlängenänderung für einen Brechungsindex von 2,0 dargestellt. Als gestrichelte Kurve ist die relative Wellenlängenänderung für einen Brechungsindex von 1,45 dargestellt. Der gestrichelten Kurve ist zu entnehmen, daß bei einem Einfallswinkel von 20° die Wellenlänge sich um 3 % gegenüber einem Einfallswinkel von 0° verändert hat, bei einem Brechungsindex von 1,45. Im Fall einer durchgelassenen Wellenlänge von 700 nm bedeutet dies eine Verschiebung um 21 nm.

In Fig. 9 ist ein viertes planparalleles Interferenzfilter 91 dargestellt. Das vierte planparallele Interferenzfilter 91 enthält eine dielektrische planparallele Platte 92. Das vierte planparallele Interferenzfilter 91 enthält ferner zwei Piezokristalle 93. Die Piezokristalle 93 sind fest mit der dielektrischen planparallelen Platte 92 verbunden. Die Piezokristalle 93 sind stabförmig. Die Piezokristalle 93 sind mit einer schmalen Seite mit der dielektrischen planparallelen Platte 92 verbunden. Sie sind an gegenüberliegenden Oberflächen der planparallelen Platte 92 senkrecht zu diesen Oberflächen angeordnet. Die Oberflächen sind diejenigen, die von Licht aus der Richtung, die durch einen Richtungspfeil 94 angedeutet ist, die dielektrische planparallele Platte 92 durchstrahlen. Die Piezokristalle 93 sind so angeordnet, daß ihre Längsachsen entlang paralleler, nicht zusammenfallender Geraden verlaufen. Die Piezokristalle 93 sind mit der jeweils der dielektrischen planparallelen Platte 92 abgewandten Seite fest mit einer Halterung 95 verbunden. Die Halterung 95 enthält zwei senkrechte Teile 951, die über ein waagerechtes Teil 952 starr miteinander verbunden sind. Die senkrechten Teile 951 haben unterschiedliche Höhe. Der Höhenunterschied ist so bemessen, daß die Piezokristalle 93, die fest mit der dielektrischen planparallelen Platte 92 verbunden sind, jeweils an der Oberkante mit dem senkrechten Teil 951 fest verbunden sind. Die Höhendifferenz der senkrechten Teile 951 entspricht also in etwa dem Abstand der Befestigungspunkte der Piezokristalle 93 an der dielektrischen planparallelen Platte 92. Da die Piezokristalle fest mit der dielektrischen planparallelen Platte 92 und mit den senkrechten Teilen 951 der starren Halterung 95 verbunden sind, führt eine Längenänderung der Piezokristalle 93 in einer Richtung, die durch Längenänderungspfeile 931 angedeutet ist, zu einer Verkippung der dielektrischen planparallelen Platte 92 um einen Winkel 97. Eine Verlängerung der Piezokristalle 93 bewirkt, daß auf die dielektrische planparallele Platte 92 ein Drehmoment wirkt. Da das Licht aus der festen Richtung, die durch den Richtungspfeil 94 angedeutet ist, auf die dielektrische planparallele Platte 92 strahlt, ändert sich durch Änderung des Winkels 97 der Einfallswinkel des Lichts auf die dielektrische planparallele Platte 92. Nach den Ausführungen zu Fig. 7 und 8 ändert sich demnach die durchgelassene Wellenlänge. Damit das Licht nach Durchgang durch die dielektrische planparallele Platte 92 in ein hinter dem vierten planparallelen Interferenzfilter 91 angeordnetes Diodenarray gelangen kann, weist der längere senkrechte Teil 951 eine Aussparung 96 auf. Die Aussparung 96 ist so angeordnet, daß Licht nach Durchgang durch die dielektrische planparallele Platte 92 ungehindert in ein Diodenarray gelangen kann.

Da bei einer Wellenlänge von 700 nm, einem Brechungsindex von 1,45 und einem Einfallswinkel von 20° die durchgelassene Wellenlänge um 21 nm verschoben wird und da im Diodenarray der Abstand zweier Empfindlichkeitsmaxima etwa 20 nm beträgt, ist das vierte planparallele Interferenzfilter gut geeignet zum Durchstimmen des Durchlaßbereiches von einem Empfindlichkeitsmaximum des Diodenarrays zu einem benachbarten durch Variation des Winkels 97 zwischen 0 und 20°.

**Patentansprüche**

1. Anordnung zur hochauflösenden Spektroskopie, die ein wellenlängenselektives Diodenarray mit nebeneinander angeordneten Diodenelementen mit unterschiedlicher spektraler Empfindlichkeit enthält, **dadurch gekennzeichnet, daß** .
zur Verbesserung der Auflösung ein Interferenzfilter (11, 41, 51, 61, 91) vorgesehen ist, bei dem der Abstand seiner Durchlaßbereiche dem Abstand der Empfindlichkeitsmaxima der einzelnen Diodenelemente entspricht und das so abstimmbar ist, daß es den gesamten Wellenlängenbereich des Diodenarrays (12, 42) abdecken kann.

2. Anordnung nach Anspruch 1, **dadurch gekennzeichnet, daß**
als Diodenarray (12, 42) ein Halbleiterschichtaufbau vorgesehen ist, der eine Schichtfolge mit stetig veränderlichem Bandabstand aufweist, und daß jede Schicht des Halbleiterschichtaufbaus mit mindestens einem Schottky-Kontakt (123, 423) zur Abnahme von Signalen versehen ist.

3. Anordnung nach Anspruch 2, **dadurch gekennzeichnet, daß**
die Oberfläche des Schichtaufbaus (122, 422) schräg zu der Schichtenfolge abgeschliffen ist und daß die Kontakte (123, 423) der Schichten auf dieser schiefen Ebene angeordnet sind.

4. Anordnung nach Anspruch 3, **dadurch gekennzeichnet, daß**
das Diodenarray (12, 42) eine Schichtenfolge aus $GaAs_{1-p}P_p$ mit $0 \leq p \leq 0,4$ aufweist.

5. Anordnung nach Anspruch 3 oder 4, **gekennzeichnet durch** folgende Merkmale:
a) das Interferenzfilter (11) ist keilförmig,
b) das Interferenzfilter (11) ist so zu dem Diodenarray (12) angeordnet, daß es zwischen einer Lichtquelle und dem Diodenarray (12) liegt und daß dabei die geneigte Oberfläche des Keils im Strahlengang liegt,
c) die Neigung des Keils verläuft in der Richtung senkrecht zur Neigung der schiefe Ebene des Diodenarrays (12),
d) die Kontakte (123) auf der schiefen Ebene sind in einem zweidimensionalen Feld angeordnet, dessen Achsenrichtungen mit den Richtungen der Neigung des Keils und der Neigung der schiefen Ebene übereinstimmen.

6. Anordnung nach Anspruch 3 oder 4, **dadurch gekennzeichnet,** daß das Interferenzfilter (41, 51, 61) planparallel ist und auf elektromechanischem Weg abstimmbar ist.

7. Anordnung nach Anspruch 6, **gekennzeichnet durch** folgende Merkmale:
a) das planparallele Interferenzfilter (61) enthält ein Joch (611),
b) in dem Joch (611) sind planparallele Platten (613) und ein Abstandsstück (612) so angeordnet, daß die Dicke des Interferenzfilters (61) über das Abstandsstück (612), das aus einem Piezokristall besteht, abstimmbar ist.

8. Anordnung nach Anspruch 6, **dadurch gekennzeichnet,** daß das Interferenzfilter (51, 91) mindestens einen Piezokristall enthält.

9. Anordnung nach Anspruch 3 oder 4, **dadurch gekennzeichnet,** daß das Interferenzfilter (61) planparallel ist und thermisch abstimmbar ist.

10. Anordnung nach Anspruch 9, **dadurch gekennzeichnet,** daß das Interferenzfilter (61) mit einem Abstandsstück (612) in einem Joch (611) aus einem Material mit geringer Wärmeausdehnung angeordnet ist und daß die Dicke des Interferenzfilters (61) durch die thermische Ausdehnung des Abstandsstücks (612) variabel ist.

11. Anordnung nach Anspruch 3 oder 4, **dadurch gekennzeichnet,** daß das Interferenzfilter (41) planparallel und elektrisch abstimmbar ist.

12. Anordnung nach Anspruch 11, **dadurch gekennzeichnet,** daß das Interferenzfilter (41) aus elektrisch doppelbrechendem Material besteht.

13. Anordnung nach einem der Ansprüche 1 bis 12, **dadurch gekennzeichnet,** daß das Diodenarray (12, 41) mit dem Interferenzfilter (11, 41, 51, 61) integriert ist.

14. Anordnung nach Anspruch 8, **gekennzeichnet durch** folgende Merkmale:
a) es sind zwei Piezokristalle (93) vorgesehen,
b) es ist eine planparallele Platte (92) vorgesehen, die aus einem dielektrischen Material besteht,
c) die Piezokristalle (93) und die planparallele Platte (92) sind so in einer Halterung (95) angeordnet, daß durch elektrische Abstimmung der Länge der Piezokristalle (93) der Neigungswinkel (97) der planparallelen Platte (92) einstellbar ist,
d) die planparallele Platte (92) ist zwischen dem Diodenarray und einer Lichtquelle so angeordnet, daß sie vom Licht durchstrahlt wird.

15. Anordnung nach Anspruch 14, **gekennzeichnet** durch folgende Merkmale:
a) die Piezokristalle (93) sind an zwei gegenüberliegenden Seiten der planparallelen Platte (92) so befestigt, daß die Längenveränderungen der Kristalle (93) senkrecht zur Oberfläche der planparallelen Platte (92) erfolgen,
b) die Piezokristalle (93) sind entlang zweier paralleler Geraden, die nicht zusammenfallen, angeordnet,
c) die Piezokristalle (93) sind mit der der planparallelen Platte (92) jeweils abgewandten Seite fest mit der Halterung (95) verbunden, die so starr ist, daß eine Längenänderung der Piezokristalle (93) zu einer Änderung des Neigungswinkels (97) der planparallelen Platte (92) führt.

## Claims

1. Arrangement for high-resolution spectroscopy, which comprises a wavelength-selective diode array having diode elements arranged next to one another and of differing spectral sensitivity, characterised in that in order to improve the resolution an interference filter (11, 41, 51, 61, 91) is provided in which the spacing of its transmission regions corresponds to the spacing of the sensitivity maxima of the individual diode elements, and which interference filter is tunable such that it can cover the entire wave band of the diode array (12, 42).

2. Arrangement according to Claim 1, characterised in that a semiconductor layer structure which has a layer sequence with continuously variable band spacing is provided as the diode array (12, 42), and in that each layer of the semiconductor layer structure is provided with at least one Schottky contact (123, 423) for receiving signals.

**3.** Arrangement according to Claim 2, characterised in that the surface of the layer structure (122, 422) is ground bevelled relative to the layer sequence, and in that the contacts (123, 423) of the layers are arranged on this inclined plane.

**4.** Arrangement according to Claim 3, characterised in that the diode array (12, 42) has a layer sequence of $GaAs_{1-p}P_p$, where $0 \leq p \leq 0.4$.

**5.** Arrangement according to Claim 3 or 4, characterised by the following features:

a) the interference filter (11) is wedge-shaped,

b) the interference filter (11) is arranged relative to the diode array (12) in such a way that it is situated between a light source and the diode array (12), and that the inclined surface of the wedge is situated in the beam path in this arrangement,

c) the slant of the wedge extends in the direction perpendicular to the slant of the inclined plane of the diode array (12),

d) the contacts (123) on the inclined plane are arranged in a two-dimensional field, the direction of the axes of which coincide with the directions of the slant of the wedge and of the slant of the inclined plane.

**6.** Arrangement according to Claim 3 or 4, characterised in that the interference filter (41, 51, 61) is plane-parallel and is tunable in an electromechanical way.

**7.** Arrangement according to Claim 6, characterised by the following features :

a) the plane-parallel interference filter (61) contains a yoke (611),

b) plane-parallel plates (613) and a spacer (612) are arranged in the yoke (611) in such a way that the thickness of the interference filter (61) above the spacer (612), which consists of a piezoelectric crystal, is tunable.

**8.** Arrangement according to Claim 6, characterised in that the interference filter (51, 91) contains at least one piezoelectric crystal.

**9.** Arrangement according to Claim 3 or 4, characterised in that the interference filter (61) is plane-parallel and thermally tunable.

**10.** Arrangement according to Claim 9, characterised in that the interference filter (61) is arranged with a spacer (612) in a yoke (611) of a material having a low thermal expansion, and in that the thickness of the interference filter (61) can be varied by the thermal expansion of the spacer (612).

**11.** Arrangement according to Claim 3 or 4, characterised in that the interference filter (41) is plane-parallel and electrically tunable.

**12.** Arrangement according to Claim 11, characterised in that the interference filter (41) consists of electrically birefringent material.

**13.** Arrangement according to one of Claims 1 to 12, characterised in that the diode array (12, 41) is integrated with the interference filter (11, 41, 51, 61).

**14.** Arrangement according to Claim 8, characterised by the following features:

a) two piezoelectric crystals (93) are provided,

b) a plane-parallel plate (92) is provided which consists of dielectric material,

c) the piezoelectric crystals (93) and the plane-parallel plate (92) are arranged in a mount (95) in such a way that the angle of inclination (97) of the plane-parallel plate (92) can be adjusted by electrical tuning of the length of the piezoelectric crystals (93),

d) the plane-parallel plate (92) is arranged between the diode array and a light source in such a way that it is transirradiated by the light.

**15.** Arrangement according to Claim 14, characterised by the following features:

a) the piezoelectric crystals (93) are secured on two opposite sides of the plane-parallel plate (92) in such a way that the length variations of the crystals (93) are effected perpendicular to the surface of the plane-parallel plate (92),

b) the piezoelectric crystals (93) are arranged along two parallel straight lines, which do not coincide, and

c) the piezoelectric crystals (93) are rigidly connected with their side respectively averted from the plane-parallel plate (92) to the mount (95), which is so rigid that a length variation in the piezoelectric crystals (93) leads to a variation in the angle of inclination (97) of the plane-parallel plate (92).

## Revendications

**1.** Dispositif de spectroscopie à haute résolution, qui comporte un réseau sélectif de diodes du point de vue des longueur d'onde et comportant des éléments de diodes disposés côte-à-côte et possédant des sensibilités spectrales différentes, caractérisé par le fait que pour améliorer la résolution, il est prévu un filtre interférentiel (11,41,51,61,91), dont la distance des bandes passantes correspond à la distance des maxima de sensibilité des différents éléments de diodes et qui peut être réglé de manière à pouvoir couvrir toute la gamme des longueurs d'onde du réseau de diodes (12,42).

2. Dispositif suivant la revendication 1, caractérisé par le fait qu'il est prévu, comme réseau de diodes (12,42), une structure à couches semiconductrices, qui comporte une succession de couches avec un écart des bandes continûment variable, et que chaque couche de la structure à couches semiconductrices comporte au moins un contact Schottky (123,423) pour le prélèvement de signaux.

3. Dispositif suivant la revendication 2, caractérisé par le fait que la surface de la structure à couches (122,422) est polie obliquement par rapport à la succession de couches, et que les contacts (123,423) des couches sont disposés dans ce plan oblique.

4. Dispositif suivant la revendication 3, caractérisé par le fait que le réseau de diodes (12,42) possède une succession de couches formées de $GaAs_{1-p}P_p$ avec $0 \leq p \leq 0,4$.

5. Dispositif suivant la revendication 3 ou 4, remarquable par les caractéristiques suivantes :
   a) le filtre interférentiel (11) possède une forme en coin,
   b) le filtre interférentiel (11) est disposé par rapport au réseau de diodes (12) de manière à être situé entre une source de lumière et le réseau de diodes (12) et que la surface inclinée du coin est située dans le trajet du rayonnement,
   c) l'inclinaison du coin s'étend dans la direction perpendiculaire à l'inclinaison du plan oblique du réseau de diodes (12),
   d) les contacts (123) sur le plan oblique sont disposés dans une zone bidimensionnelle, dont les directions axiales coïncident avec les directions de l'inclinaison du coin et de l'inclinaison du plan oblique.

6. Dispositif suivant la revendication 3 ou 4, caractérisé par le fait que le filtre interférentiel (41,51,61) est à faces planes parallèles et peut être accordé par voie électromécanique.

7. Dispositif suivant la revendication 6, remarquable par les caractéristiques suivantes :
   a) le filtre interférentiel à faces planes parallèles (61) comporte une culasse (611),
   b) des plaques parallèles (613) et une entretoise (612) sont disposées dans la culasse (611) de telle manière que l'épaisseur du filtre interférentiel (61) peut être réglée au moyen de 1'entretoise (612), qui est réalisée en un cristal piézoélectrique.

8. Dispositif suivant la revendication 6, caractérisé par le fait que le filtre interférentiel (51,91) contient au moins un cristal piézoélectrique.

9. Dispositif suivant la revendication 3 ou 4, caractérisé par le fait que le filtre interférentiel (61) est à faces planes parallèles et peut être accordé thermiquement.

10. Dispositif suivant la revendication 9, caractérisé par le fait que le filtre interférentiel (61) pourvu d'une entretoise (612) est disposé dans une culasse (611) réalisée en un matériau possédant une faible dilatation thermique et que l'épaisseur du filtre interférentiel (61) est variable sous l'effet de la dilatation thermique de l'entretoise (612).

11. Dispositif suivant la revendication 3 ou 4, caractérisé par le fait que le filtre interférentiel (41) est à faces planes parallèles et peut être accordé électriquement.

12. Dispositif suivant la revendication 11, caractérisé par le fait que le filtre interférentiel (41) est réalisé en un matériau électriquement biréfringent.

13. Dispositif suivant l'une des revendications 1 à 12, caractérisé par le fait que le réseau de diodes (12,41) est intégré dans le filtre interférentiel (11,41,51,61).

14. Dispositif suivant la revendication 8, remarquable par les caractéristiques suivantes :
   a) il est prévu deux cristaux piézoélectriques (93),
   b) il est prévu une plaque à faces planes parallèles (92), qui est réalisée en un matériau diélectrique,
   c) les cristaux piézoélectriques (93) et la plaque à faces planes parallèles (92) sont disposés dans un support (95) de telle sorte que l'angle d'inclinaison (97) de la plaque à faces planes parallèles (92) est réglable au moyen du réglage d'accord électrique de la longueur des cristaux piézoélectriques (93),

d) la plaque à faces planes parallèles (92) est disposée entre le réseau de diodes et une source de lumière de manière à être traversée par la lumière.

15. Dispositif suivant la revendication 14, remarquable par les caractéristiques suivantes :

a) les cristaux piézoélectriques sont fixés sur deux faces opposées de la plaque à faces planes parallèles (92) de telle sorte que les variations de longueur des cristaux (93) se produisent perpendiculairement à la surface de la plaque à faces planes parallèles (92),

b) les cristaux piézoélectriques (93) sont disposés suivant deux droites parallèles non coïncidentes,

c) les cristaux piézoélectriques (93) sont raccordés fermement, par leurs faces tournées respectivement à l'opposé de la plaque à faces planes parallèles (92), au support (95) qui est suffisamment rigide pour qu'une variation de la longueur des cristaux piézoélectriques (93) entraîne une variation de l'angle d'inclinaison (97) de la plaque à faces planes parallèles (92).

# FIG 1

FIG 2

# FIG 3

FIG 4

FIG 5

FIG 6

FIG 7

FIG 8

FIG 9